(19) Europäisches Patentamt
European Patent Office
Office européen des brevets

(11) **EP 1 071 208 B1**

(12) **EUROPÄISCHE PATENTSCHRIFT**

(45) Veröffentlichungstag und Bekanntmachung des Hinweises auf die Patenterteilung:
**09.11.2005  Patentblatt 2005/45**

(51) Int Cl.$^7$: **H03K 5/13**, G06F 1/04

(21) Anmeldenummer: **00114213.2**

(22) Anmeldetag: **03.07.2000**

(54) **Verfahren zur Modulation eines Grundtaktes für digitale Schaltungen und Taktmodulator zur Ausführung des Verfahrens**

Method of modulating a clock signal for digital circuits and clock modulator for carrying out said method

Procédé de modulation de signal d'horloge pour circuits numériques et modulateur d'horloge pour l'exécution de ce procédé

(84) Benannte Vertragsstaaten:
**DE FR GB IT**

(30) Priorität: **19.07.1999  DE 19933115**

(43) Veröffentlichungstag der Anmeldung:
**24.01.2001  Patentblatt 2001/04**

(73) Patentinhaber:
• **SIEMENS AKTIENGESELLSCHAFT**
  **80333 München (DE)**
• **Fujitsu Microelectronics Europe GmbH**
  **63303 Dreieich-Buchschlag (DE)**

(72) Erfinder:
• **Sattler, Frank, Dr.**
  **64832 Babenhausen (DE)**
• **Klumb, Walter**
  **55278 Mommenheim (DE)**

(56) Entgegenhaltungen:
EP-A- 0 828 360          DE-A- 19 517 265
US-A- 4 933 890          US-A- 5 252 867
US-A- 5 471 165          US-A- 5 777 501
US-A- 5 789 958

EP 1 071 208 B1

**EP 1 071 208 B1**

**Beschreibung**

Die Erfindung betrifft ein Verfahren zur Modulation eines Grundtaktes für digitale Schaltungen und einen Taktmodulator zur Modulation eines Grundtaktes für digitale Schaltungen. Eine Modulation des Grundtaktes wird angewandt, um Störungen, die durch den Grundtakt verursacht werden, breitbandiger auszugestalten und so die Störungsenergie auf zusätzliche Frequenzen zu verteilen und damit die absoluten Höhen der entstehenden Störungsspitzen zu reduzieren.

Aus der EP-A-0 930 557, veröffentlicht am 21. 07. 1999, ist ein Verfahren zur Modulation eines Grundtaktes für digitale Schaltungen und ein entsprechender Taktmodulator bekannt, bei denen die Abstände von benachbarten Schaltflanken verändert werden, wobei der jeweilige Abstand dadurch erreicht wird, daß der Grundtakt über eine wechselnde Anzahl von Verzögerungseinheiten geleitet wird und so die Abstände der benachbarten Schaltflanken verändert werden.

Aus der EP-A-0 828 360 ist ein Verfahren sowie eine Schaltungsanordnung zur Modulation eines Grundtaktes für digitale Schaltungen bekannt mit einer in Reihe geschalteten Anzahl von Verzögerungseinheiten, wobei zwischen den Verzögerungseinheiten Abgriffe angeordnet sind und der Grundtakt über eine wechselnde Anzahl von Verzögerungseinheiten geleitet wird und so die Abstände der benachbarten Schaltflanken verändert werden.

Aus der US-A-5,471,165 ist es bekannt, ein Verzögerungselement aus einer in Reihe geschalteten Anzahl von Verzögerungseinheiten aufzubauen, wobei zwischen den Verzögerungseinheiten Abgriffe angeordnet sind und ein Grundtakt über eine wechselnde Anzahl von Verzögerungseinheiten leitbar ist.

Nachteilig bei diesem Verfahren und diesem Taktmodulator ist es, dass eine Frequenzmodulation erreicht wird, die zwar die Grundfrequenz stark bedämpft, die aber in ihrem zeitlichen Mittel nicht ohne weiteres der Grundfrequenz entspricht.

Aufgabe der Erfindung ist es daher, ein Verfahren für die Frequenzmodulation eines Grundtaktes anzugeben, das einen im Mittel mit dem Grundtakt identischen modulierten Takt abgibt und einen entsprechenden Taktmodulator zur Ausführung des Verfahrens.

Die Aufgabe wird für ein Verfahren mit den Merkmalen des Anspruchs 1 gelöst.

Die Bestimmung der Abstände der Schaltflanken wird realisiert durch zyklisch wiederkehrende Zufallszahlen, von denen der jeweilige Abstand abgeleitet wird.

Erfindungsgemäß wird die Auswahl der Zufallszahlen dadurch erleichtert, dass die Zufallszahlen nach n-Zyklen für n-Zyklen invertiert werden und die invertierten Zahlen dann zur Ableitung der Schaltflanken verwendet werden. Hierdurch wird erreicht, dass auch bei einer ungünstigen Auswahl der verwendeten Zufallszahlen im Mittel die modulierte Frequenz der Grundfrequenz entspricht. Hierdurch wird es z. B. möglich, mit der modulierten Frequenz eine genaue Zeitbasis für z. B. eine Uhr zur Verfügung zu stellen.

Besonders einfach gestaltet sich diese Kalibrierung, wenn die Verzögerungsglieder stufenweise approximiert zu- bzw. weggeschaltet werden.

Besonders schnell und mit einer immer gleichen Anzahl von Schritten lässt sich diese Kalibrierung durchführen, wenn zunächst während eines Grobabgleichs in allen Verzögerungseinheiten die gleiche Anzahl von Verzögerungsgliedern zu- beziehungsweise weggeschaltet wird und dann in einem Feinabgleich jeweils ein Verzögerungsglied in einer oder mehreren Verzögerungseinheiten zu- beziehungsweise weggeschaltet wird.

Dadurch, dass die Schaltflanken zusätzlich zu der Abhängigkeit von der Zufallszahl auch in Abhängigkeit eines Modulationsgrades abgeleitet werden, lassen sich verschiedene Modulationsgrade realisieren.

Eine mögliche Ermittlung der nächsten Schaltflanke lässt sich durch die in Anspruch 6 angegebene Formel ausführen. Hierdurch sind der Modulationsgrad, die Anzahl der Verzögerungsglieder und der unterschiedlichen Zufallszahlen beziehungsweise Schaltflanken im Rahmen der physikalischen Grenzen des zu modulierenden Taktes und der Schalteinrichtung frei wählbar.

Es ist auch möglich, jeder Zufallszahl in Abhängigkeit des Modulationsgrades, des zu modulierenden Taktes und der Schalteinrichtung einen bestimmten Abstand zwischen den Schaltflanken zuzuordnen, diese Werte in einem Speicher abzulegen und bei Bedarf auszulesen und zu verwenden.

Ein erfindungsgemäßer Taktmodulator weist die Merkmale des Anspruchs 7 auf.

Durch eine Invertierungsvorrichtung zur Invertierung der Zufallszahlen wird die Auswahl der Zufallszahlen einfach. Diese Invertierungsvorrichtung ist nach n-Zyklen der Zufallszahlen zuschaltbar und nach weiteren n-Zyklen wieder abschaltbar. So lange die Zufallszahlen invertiert werden, werden die invertierten Zufallszahlen anstatt der Zufallszahlen zur Ableitung der Abstände benachbarter Schaltflanken verwendet. Hierdurch wird erreicht, daß die durchschnittliche Taktdauer der modulierten Frequenz unabhängig von der Auswahl der Zufallszahlen gleich ist der Dauer des modulierten Grundtaktes.

Die Erfindung wird nachfolgend anhand von Ausführungsbeispielen näher erläutert.

Es zeigen:

2

Fig. 1    ein Diagramm, das den Grundtakt und die Generierung des modulierten Taktes enthält,

Fig. 2    ein Blockdiagramm eines möglichen Ausführungsbeispiels,

Fig. 3    ein Ausführungsbeispiel eines besonders bevorzugten Taktmodulators,

Fig. 4    ein Funktionsdiagramm des Ausführungsbeispiels aus Fig. 3,

Fig. 5    ein Blockdiagramm eines Ausführungsbeispiels einer Verzögerungseinheit,

Fig. 6    eine Möglichkeit einer approximierten Kalibrierung von in Reihe geschalteten Verzögerungseinheiten

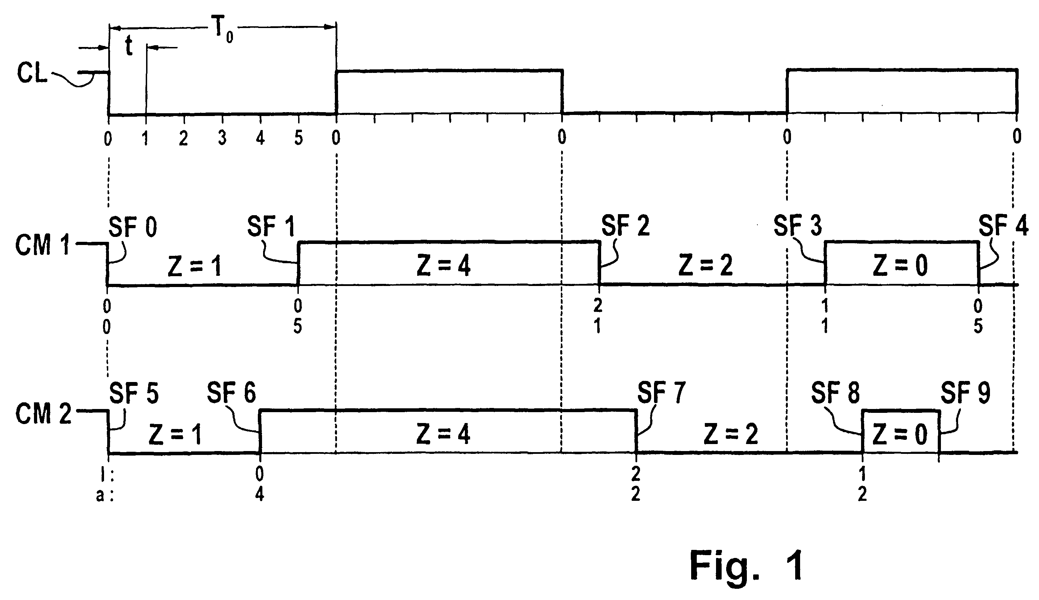

Figur 1 zeigt einen unmodulierten Grundtakt CL, dessen Halbperioden $T_0$ in jeweils 6 Abschnitte mit der Länge t = 1 aufgeteilt sind. Ein Zufallszahlengenerator liefert in periodischen Zyklen 5 unterschiedliche Zufallszahlen Z 0 bis 4. Je nach der Zufallszahl Z und dem Modulationsgrad K werden die Abstände zwischen den einzelnen Schaltflanken des zu modulierenden Taktes bestimmt. So beträgt bei der mittleren Zufallszahl (2) der Abstand zwischen den benachbarten Schaltflanken eine Halbperiode $T_0$ Bei einem Modulationsgrad von 1 ergeben sich für die übrigen Zufallszahlen folgende Abstände der Schaltflanken:

0 = 4t
1 = 5t
3 = 7t
4 = 8t

Für einen Modulationsgrad von 2 ergeben sich für die Zufallszahlen:

0 = 2t
1 = 4t
3 = 8t
4 = 10t

Eine Möglichkeit der Berechnung der jeweils nächsten Schaltflanke SF ergibt folgende Gleichung 1:

$$a_{i+1} = \left(\ a_i + p - \left(\frac{N-1}{2} - Z_{i+1}\right)K\ \right) \bmod p = X \bmod p \quad (1)$$

weiterhin ergibt sich:

$$x = l * p + a\ x*t$$

wobei l das Intervall ist in dem die nächste Schaltflanke liegt, p die Anzahl der möglichen Schaltpunkte pro Halbperiode $T_0$ und a die Lage der Schaltflanke in dem entsprechenden Intervall.

Die Berechnung der Schaltflanke des modulierten Taktes CM 1 mit dem Modulationsgrad 1 ergibt für die Zufallszahl 1 beim Beginn der letzten Schaltflanke SF 0 mit der Lage a = 0 im Intervall 0:

$$a_{i+1} = \left(0 + 6 - \left(\frac{5-1}{2} - 1\right) x\ 1\right) \bmod 6 = 5 \bmod 6$$

$$5 = l * 6 + 5 * 1$$

daraus folgt
l = 0 a=5

Dies besagt, daß die Schaltflanke SF 1 im selben Intervall bei a = 5 liegt. Sofern l = 1 beträgt, liegt die nächste Schaltflanke im nächsten Intervall, bei l = 2 liegt die Schaltflanke im übernächsten Intervall.

Für die Schaltflanke SF 2 ergibt sich:

$$a_{i+1} = \left(5 + 6 \cdot \left(\frac{5-1}{2} - 4\right) \cdot 1\right) \bmod 6 = 13 \bmod 6$$

$$13 = l * 6 + a * 1$$

l = 2  a = 1

Dies bedeutet, die Schaltflanke SF 2 liegt im übernächsten Intervall bei dem Wert a = 1.

Für die Schaltflanke SF 3 ergibt sich:

$$a_{i+1} = \left(1 + 6 \cdot \left(\frac{5-1}{2} \cdot 2\right) \cdot 1\right) \bmod 6 = 7 \bmod 6$$

$$7 = l * 6 + a * 1$$

l = 1  a = 1

Für die Schaltflanke SF 4 ergibt sich entsprechend:

$$a_{e+1} = \left(1 + 6 \cdot \left(\frac{5-1}{2} - 0\right) * 1\right) \bmod 6 = 5 \bmod 6$$

$$5 = l * 6 + a * 1$$

l = 0  a = 5

Dies bedeutet, daß die Schaltflanke SF 4 im gleichen Intervall an der Stelle 5 liegt.

Für den Takt CM 2 mit dem Modulationsgrad 2 ergeben sich für die Schaltflanken SF 6 bis SF 9:

Für die Schaltflanke SF 6:

$$a_{i+1} = \left(0 + 6 \cdot \left(\frac{5-1}{2} \cdot 1\right) * 2\right) \bmod 6 = 4 \bmod 6$$

$$4 = l * 6 + a * 1$$

l = 0  a = 4

Für die Schaltflanke SF 7:

$$a_{i+1} = \left(4 + 6 \cdot \left(\frac{5-1}{2} \cdot 4\right) * 2\right) \bmod 6 = 14 \bmod 6$$

**EP 1 071 208 B1**

$$14 = l * 6 + a * 1$$

l = 2 a = 2

Für die Schaltflanke SF 8:

$$a_{i+1} = \left(2 + 6 \cdot \left(\frac{5-1}{2} - 2\right) * 2\right) \bmod 6 = 8 \bmod 6$$

$$6 = l * 6 + a * 1$$

l = 1 a = 2

Für die Schaltflanke SF 9:

$$a_{i+1} = \left(2 + 6 \cdot \left(\frac{5-1}{2} - 0\right) \times 2\right) \bmod 6 = 4 \bmod 6$$

$$4 = l * 6 + a * 1$$

l = 0 a = 4

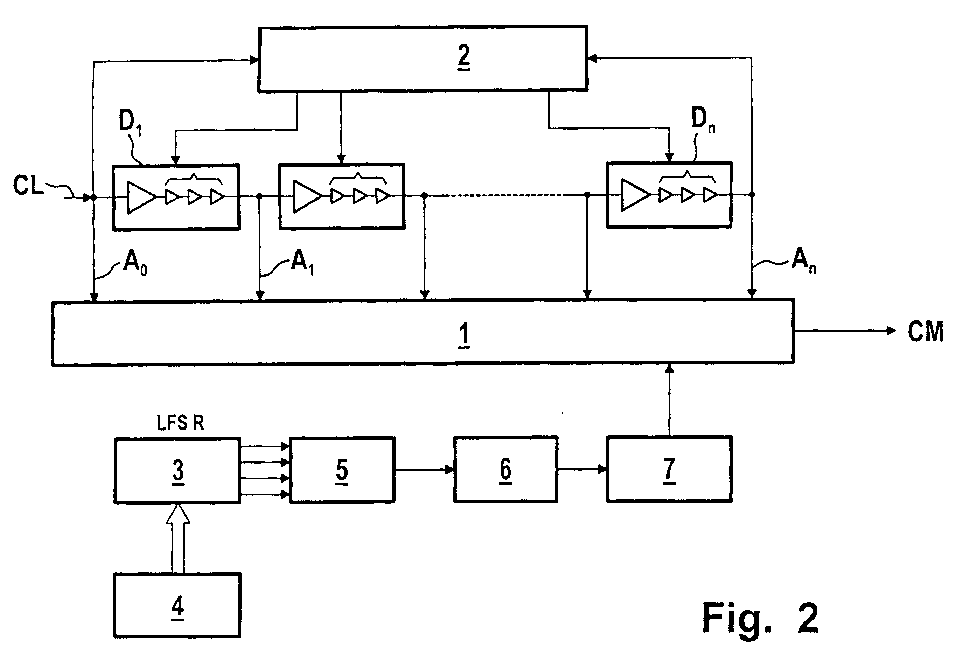

Das Blockdiagramm eines Ausführungsbeispiels des erfindungsgemäßen Taktmodulators in Figur 2 weist n in Reihe geschaltete Verzögerungseinheiten $D_1$ bis $D_n$ mit davor und dahinterliegenden Abgriffen $A_0$ bis $A_n$ die mit einem Multiplexer 1 verbunden sind. Die einzelnen Verzögerungseinheiten $D_1$ bis $D_n$ erzeugen jeweils eine Verzögerung der Länge $t = \frac{2T_o}{8}$ so daß die vollständige Verzögerungsreihe den am Eingang 6 anliegenden unmodulierten Grundtakt CL um insgesamt eine Periode verzögern. Eine Kalibriervorrichtung 2 vergleicht den am Eingang E anliegenden Grundtakt CL mit dem am Ausgang $A_n$ des letzten Verzögerungsgliedes $D_n$ anliegenden Signals. Stimmen die Zeitpunkte der Schaltflanken der beiden Signale nicht überein, kalibriert die Kalibriervorrichtung 2 die Verzögerungseinheiten $D_1$ bis $D_n$ so, daß die beiden Signale übereinstimmen.

Mit Hilfe eines rückgekoppelten Schieberegisters 3 werden m Zufallszahlen zyklisch erzeugt.

Über eine Intialisierungsvorrichtung 4 können verschiedene Zufallszahlenfolgen ausgewählt werden.

Sobald ein Zyklus der Zufallszahlen beendet ist, werden während des nachfolgenden Zyklus mit einem Invertierer 5 die aus dem rückgekoppelten Schiebregister ausgelesenen Zufallszahlen invertiert, um eine gleichmäßige Verteilung der Zufallszahlen und damit der unterschiedlichen Verzögerungen zu erhalten. Wenn eine gerade Anzahl von verschiedenen Zufallszahlen vorhanden ist, wird diese in einer Mapvorrichtung 6 um eins reduziert, so daß eine ungerade Anzahl von verschiedenen Zufallszahlen gegeben ist. Diese Reduzierung kann zum Beispiel dadurch realisiert sein, daß beim Vorliegen der höchsten Zufallszahl nicht diese genommen wird, sondern nacheinander die übrigen Zufallszahlen. Dies kann zum Beispiel dadurch geschehen, daß beim Vorliegen dieser höchsten Zufallszahl ein Zähler, der von Null bis zu der noch erlaubten höchsten Zufallszahl zählt, ausgelesen wird und dann um eins hochgesetzt wird.

Die so erhaltenen Zufallszahlen werden, wie zuvor zu Figur 1 beschrieben, in der Recheneinheit 7 verwendet, um den Abgriff $A_0$ bis $A_n$ zu bestimmen, auf den der Multiplexer 1 geschaltet werden muß, damit die der Zufallszahl und dem Modulationsgrad entsprechende Schaltflanke erzielt wird.

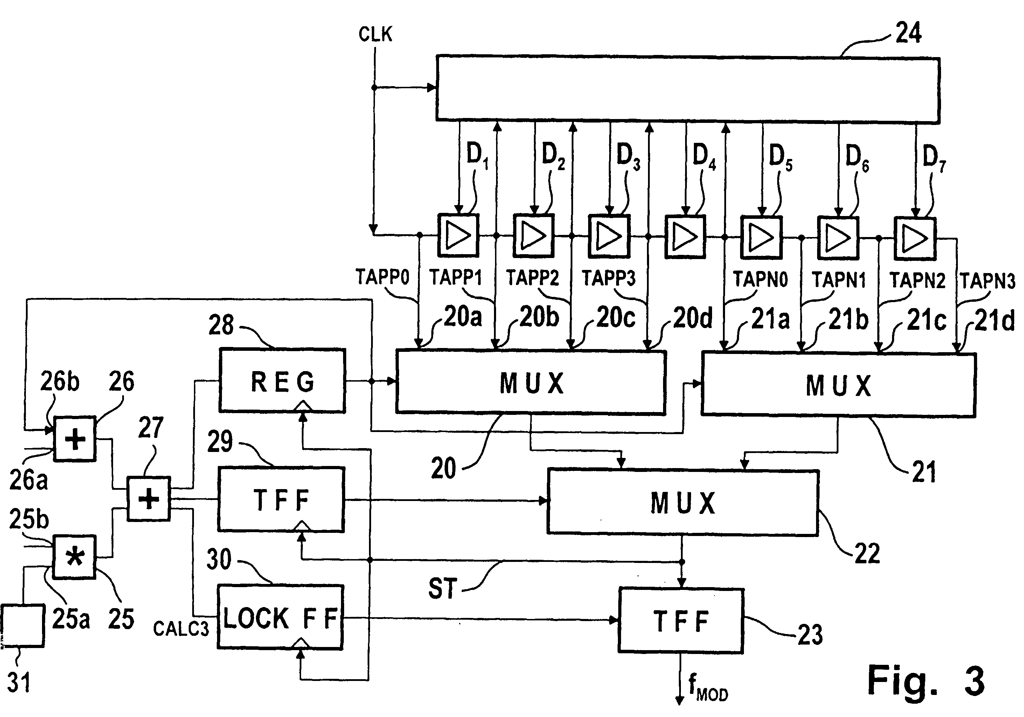

In Figur 3 sind 7 Verzögerungseinheiten $D_1$ - $D_7$ zu einer Verzögerungskette in Reihe geschaltet, über die der Grundtakt CLK geleitet wird. Der Grundtakt CLK (entsprechend dem Signal TAPP0) und die Signale TAPP1 - P3, die die Verzögerungseinheiten $D_1$ - $D_3$ verlassen, liegen jeweils an einem Eingang 20a - d eines Multiplexers 20 an, die Signale TAP N0 - N3, die die Verzögerungseinheiten $D_4$ - $D_7$ verlassen, an jeweils einem Eingang 21 a - d des Multiplexers 21. Die Ausgänge der Multiplexer 20, 21 sind mit den Eingängen eines Multiplexers 22 verbunden, dessen Ausgang an den Eingang eines Toggle Flipflop 23 anliegt, an dessen Ausgang der modulierte Takt $f_{MOD}$ anliegt.

Die Signale TAPP0 - TAPP3 werden zusätzlich auch an eine Kalibriereinheit 24 gegeben, die überwacht, ob die Verzögerung dieser Signale korrekt ist. Ist dies nicht der Fall, werden die Verzögerungseinheiten $D_1$ - $D_4$ so lange kalibriert bis die Verzögerung stimmt. Die für Verzögerungseinheiten $D_1$ - $D_4$ ermittelten Werte werden auch für die Verzögerungseinheiten $D_5$ bis $D_7$ übernommen, da sie die gleichen Betriebsparameter aufweisen wie die Verzöge-

**5**

rungseinheiten $D_1$ - $D_4$, insbesondere wenn alle Verzögerungseinheiten $D_1$ - $D_7$ oder sogar der gesamte Taktmodulator in einem IC integriert sind. Diese Kalibrierung kann ständig oder in bestimmten zeitlichen Abständen erfolgen oder beispielsweise bei Änderungen bestimmter Parameter wie beispielsweise Temperatur oder Schaltung durchgeführt werden.

Figur 3 zeigt weiterhin einen Multiplizierer 25, zwei Addierer 26, 27, ein Register 28, ein Toggle-Flipflop 29, ein Lock-Flipflop 30 und einen Zufallszahlengenerator 31.

Die Gleichung 1 läßt sich folgendermaßen umschreiben:

$$S = a_{i+1} = (a_i + K * Z_{i+1} + c) \bmod p$$

wobei $c = p - ((N-1) : 2) * K$

Am Eingang 25a liegt die nächste Zufallszahl $Z_{i+t}$ an, am Eingang 25b der Modulationsgrad K, am Eingang 26a liegt die Konstante c an und am Eingang 26b die Lage a, der vorhergehenden Schaltflanke SF, die aus dem Register 28 ausgelesen wird. Das Produkt aus dem Multiplizierer 25 und die Summe aus dem Addierer 26 werden im Addierer 27 zu einer Summe S zusammengezählt. Das oberste Bit dieser Summe S wird an den Setzeingang des Lock-Flipflop 30 geführt, das zweithöchste Bit an den Eingang des Toggle-Flipflop 29 und die beiden restlichen, unteren Bit an das Register 28. Der Ausgang des Registers 28 steuert die beiden Multiplexer 25, 26 an und wird weiterhin auf einen Eingang des Addierers 26 zurückgekoppelt.

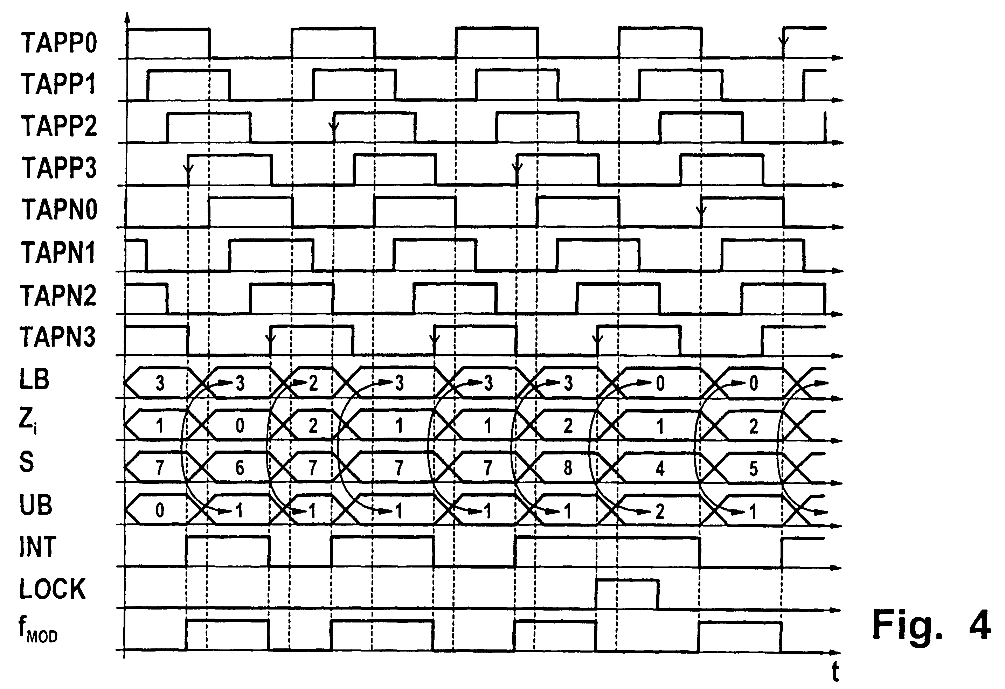

In Figur 4 ist eine beispielhafte Darstellung der Funktionsweise des vorbeschriebenen Taktmodulators in Form eines Diagramms dargestellt. Hierbei bedeuten TAPP0 bis TAPP3 die Signale, die an den Eingängen des Multiplexers 20, TAPN0 bis N3 die Signale, die an den Eingängen des Multiplexers 21 anliegen. LB bedeutet die Zahl die die untersten beiden Bit der Summe S ergeben und repräsentiert damit die Nummer des Signals TAPP0 - TAPP3 bzw. TAPN0 - TAPN3, $Z_i$ die jeweils vorliegende Zufallszahl, UB die Zahl der beiden oberen Bit der Summe S, INT den Ausgang des Toggle-Flipflop 29 und LOCK den Ausgang des Lock-Flipflop 30.

Die Anzahl der möglichen Zufallszahlen Z sei = 3, nämlich 0,1 und 2, die Anzahl der möglichen Schaltpunkte p pro Halbperiode $T_0$ ist 4 (nämlich jeweils die steigende Flanke von TAPP0 bis P3 bzw. TAPN0 bis N3) und der Modulationsgrad sei K = 1.

Somit kann die Summe S Werte von 3 bis 8 betragen, digital geschrieben:

|   | UB | LB |
|---|----|----|
| 3 | 00 | 11 |
| 4 | 01 | 00 |
| 5 | 01 | 01 |
| 6 | 01 | 10 |
| 7 | 01 | 11 |
| 8 | 10 | 00 |

Die Modulation beginnt mit dem Wert 3 im Register 28, die Zufallszahl $Z_i$ = 1 und die Ausgänge der Flipflop 29, 30 seien auf 0. Wenn am Eingang des Multiplexers 22 der Wert 0 anliegt, schaltet er auf den Multiplexer 20 durch, beim Wert 1 auf den Multiplexer 21. Die 3 bedeutet, daß der Eingang TAPP3 bzw. TAPPN 3 der Multiplexer 21 durchgeschaltet wird, so daß das Signal, das nach der Verzögerungseinheit D3 anliegt, durchgeschaltet wird, das bei seiner nächsten positiven Flanke den Ausgang des Toggle-Flipflop 23 umschalten wird.

Der parallel dazu berechnete nächste durchzuschaltende Eingang:

$$S = 3 + 1 \times 1 + 3 = 7 \text{ oder binär } 0\ 1\ 1\ 1$$

wird mit der nächsten positiven Flanke des Signals ST, das den Multiplexer 22 verläßt, in das Register 28, das Toggle-Flipflop 29 und das Lock-Flipflop 30 übernommen. Somit weisen die unteren beiden Bit UB = 11 = 3 und die oberern Bit 01 = 1 auf. Im Register 28 steht also eine 3, so daß die Eingägen TAPP3 und TAPN3 durchgeschaltet werden, das zweithöchste Bit ist eine 1, so daß das Toggle-Flipflop 29 seinen Ausgang umschaltet, und zwar von der 0 auf die 1, so daß das Signal am Ausgang von Multiplexer 21 durchgeschaltet wird. Somit schaltet die positive Flanke von TAPN3 das Toggle-Flipflop 23 wieder auf 0. Die weitere Berechnung läuft entsprechend. Wenn die Summe S = 8 beträgt, digital 1000, sperrt das Lock-Flipflop 30 das Toggle-Flipflop 23, so daß es nicht seinen Ausgang ändern kann.

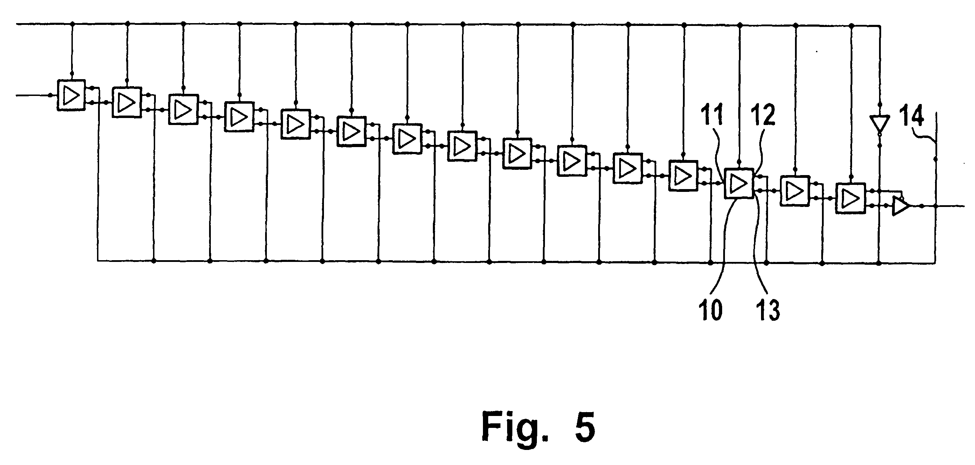

In Figur 5 erkennt man den möglichen Aufbau einer Verzögerungseinheit D. Die Verzögerungseinheit D be-

EP 1 071 208 B1

steht aus m in Reihe geschalteten Verzögerungsgliedern 10. Die Verzögerungsglieder 10 weisen jeweils einen Takteingang 11, zwei Taktausgänge 12, 13 und einen Steuereingang 14 auf. Der jeweilige Taktausgang 12 ist mit dem Ausgang 14 der Verzögerungseinheit D verbunden, während der jeweilige Taktausgang 13 mit dem Takteingang 11 des jeweils folgenden Verzögerungsgliedes 10 verbunden ist. Durch die Steuereingänge 14 wird bestimmt, an welchem Taktausgang 12, 13 das (verzögerte) Taktsignal anliegt und damit, ob das Taktsignal weiterverzögert werden soll oder unverzögert zum Ausgang 14 gelangen soll. Somit läßt sich die Verzögerungszeit jeder Verzögerungseinheit D in großem Bereich variieren.

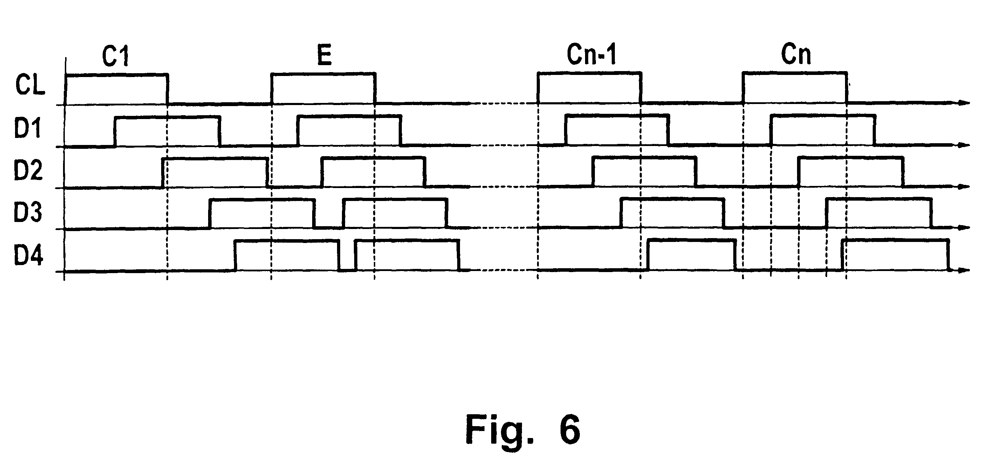

Das Ablaufdiagramm in Fig. 6 zeigt eine Möglichkeit einer approximierten Kalibrierung der Verzögerungseinheiten aus Fig. 3. Zunächst werden im ersten Zyklus C1 in jeder Verzögerungseinheit D1- D4 die gleiche Anzahl von Verzögerungsgliedern eingesetzt, um den Takt CL zu verzögern. Da bei der Verzögerungseinheit D4 der Takt mehr als eine vollständige halbe Periode verzögert ist, werden in den Verzögerungseinheiten D1 - D4 jeweils eine gleiche Anzahl von Verzögerungsgliedern weggeschaltet. Dies wird in mehreren Schritten mit abnehmende Anzahl durchgeführt, bis durch Zu- oder Wegschalten jeweils eines Verzögerungsgliedes in jeder Verzögerungseinheit bei der Verzögerungseinheit D4 der Takt um fast eine halbe Periode verzögert ist und das Ende E der Grobkalibrierung erreicht ist. Dann werden während der Feinkalibrierung einzelne Verzögerungsglieder in einigen oder einer Verzögerungseinheit zu- oder weggeschaltet, bis im vorletzten Schritt Cn-1 bei der Verzögerungseinheit D4 der Takt um mehr als eine halbe Periode verzögert ist, um dann im letzten Schritt Cn durch Wegschalten eines Verzögerungsgliedes die Reihe der Verzögerungseinheiten so kalibriert zu haben, daß bei der Verzögerungseinheit D4 der Takt um weniger als die Zeitdauer der Verzögerung eines Verzögerungsgliedes kürzer als eine halbe Periode eines Taktes verkürzt wird.

Die Verzögerungseinheiten D5 - D7 werden dann entsprechend eingestellt.

Es ist auch möglich, alle Verzögerungseinheiten D1 - D7 gleichzeitig abzugleichen, wenn nach der Verzögerungseinheit D7 noch eine weitere, nicht dargestellte Verzögerungseinheit angeordnet ist und die Verzögerungseinheiten solange in der vorbeschriebenen Weise abgeglichen werden durch Zu- beziehungsweise Wegschalten von Verzögerungsgliedern, bis der Takt am Ausgang der nicht dargestellten Verzögerungseinheit um die Dauer einer vollen Periode verzögert ist.


**Patentansprüche**

1. Verfahren zur Modulation eines Grundtaktes für digitale Schaltungen, bei dem die Abstände benachbarter Schaltflanken verändert werden, wobei der Grundtakt über eine wechselnde Anzahl von Verzögerungseinheiten geleitet wird und so die Abstände der benachbarten Schaltflanken verändert werden, wobei die Verzögerungszeiten der Verzögerungseinheiten (D1 - Dn) kalibriert werden, wobei die Verzögerungseinheiten (D1 - Dn) jeweils mehrere Verzögerungsglieder (10) aufweisen, die einzeln und/oder in Gruppen zu- bzw. weggeschaltet werden und wobei der jeweilige Abstand zweier benachbarter Schaltflanken von Zahlen eines Zufallszahlengenerators abgeleitet wird und der Zufallszahlengenerator zyklisch wiederkehrende Zufallszahlen erzeugt, **dadurch gekennzeichnet, dass** die Zufallszahlen für n-Zyklen ausgelesen werden, dass die Zufallszahlen nach den n-Zyklen für n-Zyklen invertiert werden und diese invertierten Zufallszahlen zur Ableitung der Abstände benachbarter Schaltflanken verwendet werden.

2. Verfahren nach Anspruch 1, **dadurch gekennzeichnet, dass** zur Kalibrierung der Verzögerungseinheiten (D1 - D7) die Verzögerungsglieder (10) stufenweise approximiert zu- beziehungsweise weggeschaltet werden.

3. Verfahren nach Anspruch 2, **dadurch gekennzeichnet, dass** zunächst während eines Grobabgleichs in allen Verzögerungseinheiten (D1 - D7) jeweils die gleiche Anzahl Verzögerungsglieder (10) zu- beziehungsweise weggeschaltet wird und dann in einem Feinab-, gleich jeweils ein Verzögerungsglied (10) in einer oder mehreren Verzögerungseinheiten (D1 - D7) zu- oder weggeschaltet wird.

4. Verfahren nach Anspruch 2, **dadurch gekennzeichnet, dass** in einer Reihe von Verzögerungseinheiten (D1 - D4), die sich von der ersten Verzögerungseinheit (D1) bis zu der Verzögerungseinheit (D4) erstreckt, an deren Ausgang bei korrekter Verzögerung der Takt um eine halbe Periode verzögert wird, während eines Grobabgleichs in allen Verzögerungseinheiten (D1 - D4) jeweils die gleiche Anzahl Verzögerungsglieder (10) zu- beziehungsweise weggeschaltet wird und dann in einem Feinabgleich jeweils ein Verzögerungsglied (10) in einer oder mehreren Verzögerungseinheiten (D1 - D4) zu- oder weggeschaltet wird, bis am Ausgang der letzten Verzögerungseinheit (D4) der Reihe der Takt um eine halbe Periode verzögert wird, dass anschließend die restlichen Verzögerungseinheiten (D5 - D7) entsprechend eingestellt werden.

5. Verfahren nach einem der vorstehenden Ansprüche, **dadurch gekennzeichnet, dass** in Abhängigkeit der Zufallszahl und eines Modulationsgrades der Abstand zwischen zwei aufeinanderfolgenden Schaltflanken abgeleitet wird.

6.  Verfahren nach Anspruch 5, **dadurch gekennzeichnet, dass** die Lage einer auf eine Schaltflanke ($a_i$) folgenden Schaltflanke ($a_{i+1}$) wie folgt berechnet wird:

$$a_{i+1} = ( a_i + p - \left( \frac{N-1}{2} - Z_{i+1} \right) K ) \bmod p$$

wobei

p   die Anzahl der Verzögerungsschritte pro Halbperiode,
N   die Anzahl der möglichen Schaltflanken,
K   den Modulationsgrad und
Z   die Zufallszahl

darstellt.

7.  Taktmodulator, der eine in Reihe geschaltete Anzahl von Verzögerungseinheiten aufweist, wobei zwischen den Verzögerungseinheiten Abgriffe angeordnet sind und der Grundtakt über eine wechselnde Anzahl von Verzögerungseinheiten leitbar und so der Abstand zwischen den Schaltflanken veränderbar ist zur Ausführung des Verfahrens nach einem der vorstehenden Ansprüche, wobei die Verzögerungszeiten der Verzögerungseinheiten einstellbar und kalibrierbar sind, wobei die Verzögerungseinheiten in Reihe geschaltete Verzögerungsglieder aufweisen, die einzeln zu- und abschaltbar sind und wobei mit einem Zufallszahlengenerator zyklisch wiederkehrende Zufallszahlen erzeugbar sind und aus den Zufallszahlen die Abstände benachbarter Schaltflanken ableitbar sind, **dadurch gekennzeichnet, dass** eine Invertierungsvorrichtung zur Invertierung der Zufallszahlen vorhanden ist, dass die Invertierungsvorrichtung nach n-Zyklen zu- und nach weiteren n-Zyklen wieder abschaltbar ist, dass aus den invertierten Zufallszahlen statt aus den Zufallszahlen die Abstände benachbarter Schaltflanken ableitbar sind.

**Claims**

1.  Method for modulating a basic clock signal for digital circuits, in which the distances between adjacent switching edges are altered, the basic clock signal being conducted via a changing number of delay units and the distances between the adjacent switching edges being altered in this way, the delay times of the delay units (D1-Dn) being calibrated, the delay units (D1-Dn) each having a plurality of delay elements (10) which are connected in or out individually and/or in groups and the respective distance between two adjacent switching edges being derived from numbers of a random number generator and the random number generator generating cyclically recurring random numbers, **characterized in that** the random numbers are read out for n cycles, **in that** the random numbers are inverted after the n cycles for n cycles and these inverted random numbers are used for deriving the distances between adjacent switching edges.

2.  Method according to Claim 1, **characterized in that**, in order to calibrate the delay units (D1-D7), the delay elements (10) are connected in or out in a stepwise approximated manner.

3.  Method according to Claim 2, **characterized in that**, firstly, during a coarse calibration, the same number of delay elements (10) is connected in or out in each case in all the delay units (D1-D7) and then, in a fine calibration, a respective delay element (10) in one or more delay units (D1-D7) is connected in or out.

4.  Method according to Claim 2, **characterized in that**, in a series of delay units (D1-D4) which extends from the first delay unit (D1) up to the delay unit (D4), at whose output the clock signal is delayed by half a period given a correct delay, during a coarse calibration, the same number of delay elements (10) is connected in or out in each case in all the delay units (D1-D4) and then, in a fine calibration, a respective delay element (10) in one or more delay units (D1-D4) is connected in or out until, at the output of the last delay unit (D4) of the series, the clock signal is delayed by half a period, **in that** the remaining delay units (D5-D7) are subsequently set in a corresponding manner.

**5.** Method according to one of the preceding claims, **characterized in that** the distance between two successive switching edges is derived as a function of the random number and a modulation factor.

**6.** Method according to Claim 5, **characterized in that** the position of a switching edge ($a_{i+1}$) succeeding a switching edge ($a_i$) is calculated as follows:

$$a_{i+1} \;=\; \left(a_i + p - \left(\frac{N-1}{2} - Z_{i+1}\right)K\right)\bmod p$$

where

    p represents the number of delay steps per half-period,
    N represents the number of possible switching edges,
    K represents the modulation factor and
    Z represents the random number.

**7.** Clock modulator having a number of delay units connected in series, taps being arranged between the delay units and the basic clock signal being able to be conducted via a changing number of delay units and the distance between the switching edges being able to be altered in this way, for implementing the method according to one of the preceding claims, the delay times of the delay units being adjustable and calibratable, the delay units having series-connected delay elements which can be connected in and disconnected individually, and cyclically recurring random numbers being able to be generated by a random number generator, and the distances between adjacent switching edges being able to be derived from the random numbers, **characterized in that** an inverting device for inverting the random numbers is present, **in that** the inverting device can be connected in after n cycles and can be disconnected again after a further n cycles, **in that** the distances between adjacent switching edges can be derived from the inverted random numbers instead of from the random numbers.

## Revendications

**1.** Procédé permettant de moduler une fréquence d'horloge pour circuits numériques, au cours duquel les écarts entre flancs de commutation voisins sont modifiés, la fréquence d'horloge étant envoyée sur un nombre changeant d'unités de temporisation et les écarts entre les flancs de commutation voisins étant ainsi modifiés, les durées de temporisation des unités de temporisation (D1 - Dn) étant calibrées, les unités de temporisation (D1 - Dn) comportant plusieurs éléments de temporisation (10), qui sont connectés ou, respectivement, déconnectés un par un et / ou en groupes et l'écart respectif entre deux flancs de commutation voisins étant déduit de nombres provenant d'un générateur de nombres aléatoires et le générateur de nombres aléatoires générant des nombres aléatoires revenant périodiquement, **caractérisé par le fait que** les nombres aléatoires sont lus pour n cycles, que, après n cycles, les nombres aléatoires sont invertis pour n cycles et que ces nombres aléatoires invertis sont utilisés pour en déduire les écarts entre flancs de commutation voisins.

**2.** Procédé selon la revendication 1 **caractérisé par le fait que**, pour le calibrage des unités de temporisation (D1 - D7), les éléments de temporisation (10) sont connectés ou, respectivement, déconnectés en approximation pas à pas.

**3.** Procédé selon la revendication 2 **caractérisé par le fait que**, d'abord, pendant un réglage grossier, dans toutes les unités de temporisation (D1 - D7), le même nombre d'éléments de temporisation (10) est connecté ou, respectivement, déconnecté, puis, pendant un réglage fin, dans chaque cas, un élément de temporisation (10) est connecté ou, respectivement, déconnecté dans une ou plusieurs unités de temporisation (D1 - D7).

**4.** Procédé selon la revendication 2 **caractérisé par le fait que**, dans une série d'unités de temporisation (D1 - D4), qui s'étend de la première unité de temporisation (D1) jusqu'à l'unité de temporisation (D4), à la sortie de cette dernière, si la temporisation est correcte, la fréquence d'horloge est retardée d'une demi-période, que pendant un réglage grossier, dans toutes les unités de temporisation (D1 - D4), le même nombre d'éléments de temporisation (10) est connecté ou, respectivement, déconnecté, puis, pendant un réglage fin, dans chaque cas, un élément de temporisation (10) est connecté ou, respectivement, déconnecté dans une ou plusieurs unités de temporisation (D1 - D4), jusqu'à ce que, à la sortie de la dernière unité de temporisation (D4) de la série, la fréquence d'horloge est retardée d'une demi-période, et que, ensuite, les autres unités de temporisation (D5 - D7) sont réglées d'une façon correspondante.

5. Procédé selon l'une des revendications précédentes **caractérisé par le fait que** l'écart entre deux flancs de commutation qui se suivent est déduit en fonction du nombre aléatoire et d'un degré de modulation.

6. Procédé selon la revendication 5 **caractérisé par le fait que** la position d'un flanc de commutation ($a_{i+1}$) qui suit un flanc de commutation ($a_i$) est calculée de la façon suivante:

$$a_{i+1} = \left( a_i + p - \left( \frac{N-1}{2} - Z_{i+1} \right) K \right) \bmod p,$$

dans laquelle

   p est le nombre de pas de temporisation par demi-période,
   N est le nombre de flancs de commutation possibles,
   K est le degré de modulation et
   Z est le nombre aléatoire.

7. Modulateur de fréquence d'horloge, qui comporte un certain nombre d'unités de temporisation montées en série, où des sorties sont disposées entre les unités de temporisation et où la fréquence d'horloge de base peut être envoyée à travers un nombre changeant d'unités de temporisation et, ainsi, l'écart entre les flancs de commutation être modifié, destiné à exécuter le procédé selon l'une des revendications précédentes, les durées de temporisation des unités de temporisation étant réglables et calibrables, où les unités de temporisation ont des éléments de temporisation montés en série, qui peuvent être mis en circuit ou déconnectés séparément et où des nombres aléatoires revenant cycliquement peuvent être générés par un générateur de nombres aléatoires et où les écarts entre flancs de commutation voisins peuvent être déduits des nombres aléatoires, **caractérisé par le fait qu'**il y a un dispositif d'inversion destiné à invertir les nombres aléatoires, que le dispositif d'inversion peut être connecté après n cycles et être déconnecté après n autres cycles, que les écarts entre flancs de commutation voisins peuvent être déduits des nombres aléatoires invertis à la place des nombres aléatoires.

Fig. 1

EP 1 071 208 B1

Fig. 2

Fig. 3

Fig. 4

EP 1 071 208 B1

Fig. 5

Fig. 6